Europäisches Patentamt

European Patent Office

Office européen des brevets

(1) Publication number: **0 277 118**
**B1**

(12) **EUROPEAN PATENT SPECIFICATION**

(45) Date of publication of patent specification: **04.04.90**

(21) Application number: **86905127.6**

(22) Date of filing: **19.08.86**

(86) International application number:
**PCT/US86/01690**

(87) International publication number:
**WO 88/01314 25.02.88 Gazette 88/05**

(51) Int. Cl.⁵: **C 25 D 5/02**

(54) **REMOVABLE COMMONING BAR.**

(43) Date of publication of application:
**10.08.88 Bulletin 88/32**

(45) Publication of the grant of the patent:
**04.04.90 Bulletin 90/14**

(84) Designated Contracting States:
**CH DE FR GB IT LI NL SE**

(56) References cited:
**US-A-2 834 723**
**US-A-4 000 045**

(73) Proprietor: **INTERNATIONAL BUSINESS MACHINES CORPORATION**
**1701 North Street (N50/251-2)**
**Endicott, NY 13760 (US)**

(72) Inventor: **CIBULSKY, Michael, J.**
**12 Matthews Street**
**Binghamton, NY 13905 (US)**

(74) Representative: **Combeau, Jacques et al**
**Compagnie IBM France Département de Propriété Intellectuelle**
**F-06610 La Gaude (FR)**

EP 0 277 118 B1

## Description

### Field of the Invention

This invention relates generally to the manufacture of printed circuit boards and more specifically to an improved method for electroplating portions of a conductive circuit on a dielectric substrate.

### Prior Art

Printed circuit boards are well known in the computer industry. Generally, they comprise planar dielectric substrates on which a conductive circuit has been made. The conductive circuit is used to enable electrical communication between components of a computer.

The dielectric substrates may be formed from a wide variety of materials including, for example, resins or resin-impregnated papers or fabric. The conductive circuits may be formed from insulated wiring attached to the surface of the dielectric substrate in a suitable pattern or from conductive material placed on the dielectric substrate in such a pattern.

Conductive metal circuits may be placed on the substrate by a variety of already known methods. In "subtractive" methods, the substrate is usually first coated with a layer of conductive metal by, for example, lamination. The metal is exposed to a pattern of light which causes a portion of the photoresist to harden while the remainder may be removed, resulting in a mask. The mask protects portions of the conductive layer while the unprotected portion is removed by, for example, acid or etching. The photoresist mask may then be removed, leaving a printed circuit on the dielectric substrate.

In "additive" methods for placing a conductive pattern on a substrate, the substrate is seeded with a catalytic material which enables the electroless deposition of conductive metals, such as copper from a plating bath. After seeding and before electroless plating a photoresist mask is placed on the substrate so that a pattern of conductive metal is deposited. Electroplating may be used to build up the circuit after a thin conductive pattern has been formed by the electroless plating method.

In some computer designs, a printed circuit board is connected to the frame of the computer by connectors on the frame which make contact with conductive lands or pads along the edge of the printed circuit board. Alternatively, connectors comprising cable assemblies may be connected to such lands or pads for communication between the printed circuit board and more remote components. In order to make good electrical contact it is often desirable to deposit a thin layer of a noble metal such as gold, silver or palladium on the lands or pads.

Electroplating noble metals onto lands or pads around the edges of printed circuit boards is an important part of the manufacture of such boards. Such electroplating is normally done by electrically commoning the lands or pads sought to be plated and then accomplishing the electroplating by dipping in an electroplating bath or by jet plating, which is also an electroplating technique.

Commoning of the lands or pads can be done in a variety of ways. Strip electrodes can be used. Electrical strips which are imbedded in an insulating tape are sometimes used.

Good results have been achieved by using a commoning bar which is a part of the printed circuit board. The "printed" commoning bar electrically connects the lands and pads which are to be electroplated. After the plating procedure the commoning bar is removed so that the lands and pads are no longer electrically connected.

Removal of the commoning bar which is part of the printed circuit on the printed circuit board has presented difficulties to those involved in the manufacture of printed circuit boards. The most successful means of removing the commoning bar in the past has been to cut away the portion of the printed circuit board which includes the commoning bar. This technique is illustrated in Japanese Patent Publication 36—18276. Although effective, this method destroys a portion of the board, uses up valuable printed circuit board area and results in the debris normally encountered in cutting or sawing.

### Summary of the Invention

It is an object of the present invention to overcome disadvantages of the prior art.

It is also an object of this invention to provide an improved method for making printed circuit boards having electroplated portions.

It is a further object of this invention to present an improved method for removing an electrical commoning bar from a printed circuit board after electroplating portions of the printed circuit on the board.

These and other objects are provided by the present invention which, in one aspect, is a method of making a printed circuit board having a conductive pattern on a dielectric substrate and having selected portions of the conductive pattern electroplated, the method comprising:

(a) placing on a dielectric substrate a conductive pattern, which pattern includes a commoning portion electrically connecting the selected portions.

(b) electroplating the selected portions using the commoning portion as a commoning electrode, and

(c) removing the commoning portion from the substrate by peeling:—

In another aspect the present invention relates to a printed circuit board made by this process.

By way of example, the present invention is described, below, with reference to the drawings which are intended to be illustrative but not to be limiting.

### Brief Description of the Drawings

FIG. 1 shows a schematic view of a pattern of lands or pads along the edge of a printed circuit board electrically connected by a commoning bar.

FIG. 2 shows schematically the commoning bar being removed in accordance with the method of the present invention.

## Detailed Description

It has been discovered that a commoning bar which electrically connects portions of a printed circuit can be removed from the printed circuit board, after electroplating selected portions of the printed circuit board, by peeling, leaving the electroplated portions of the board in place and electrically separated, while avoiding the disadvantages of the prior art.

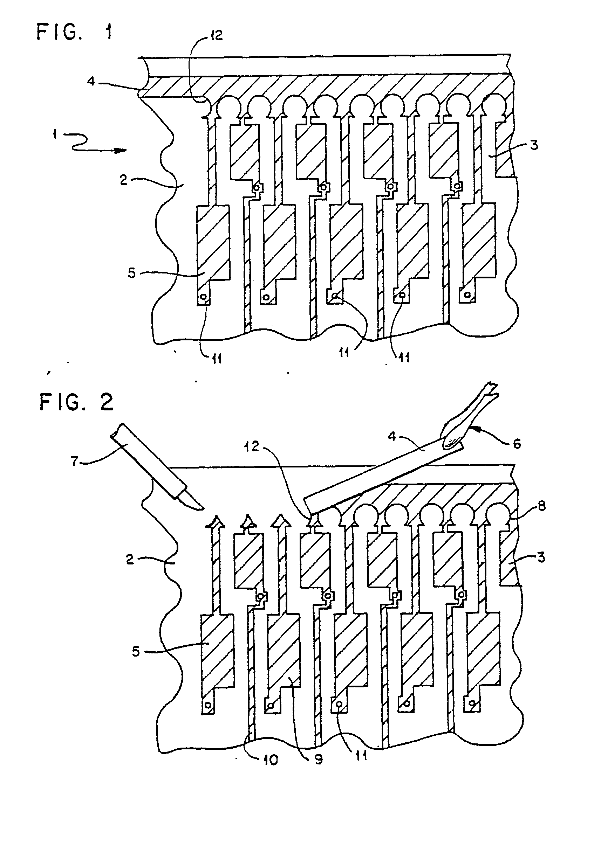

Referring to FIG. 1, there is shown printed circuit board 1 wich comprises dielectric substrate 2 and conductive pattern 3. FIG. 1 shows only a portion of substrate 2 and a portion of printed circuit 3.

As described above, the printed circuit board may be made from any of the materials which are well known as dielectric substrates and conductive materials. The selection of the materials is not critical to the performance of the invention.

Printed circuit 3 includes commoning bar portion 4 and lands or pad portion 5. The lands or pads are designed for contact with connectors which will permit the processing units on board 2 to communicate with other parts of the computer which includes the printed circuit board.

Commoning bar portion 4 of printed circuit 3 electrically connect portions 5 of the printed circuit board. In the normal construction of a printed circuit board it would be desirable to electroplate portions 5 of circuit 3 with a noble metal in order to improve electrical contact with connectors, as explained above.

After printed circuit 3 is made as shown in FIG. 1 with portions 5 electrically connected by commoning bar portion 4, portions 5 are electroplated. Normally a noble metal is selected for electroplating on portions 5 because of the good ohmic contact which is well known to be achieved by the use of such metals in connectors.

The particular metal used and the particular electroplating mechanism used are not critical to the operation of the invention. Any useful metal and electroplating method may be used.

Referring to FIG. 2, there is shown printed circuit board 1 in which commoning bar 4 is removed from the surface of substrate 2 after electroplating. Commoning bar portion 4 is removed by peeling it away from surface 2.

Peeling may be done in any of a number of ways. Any useful such way may be employed in the method of the present invention. In FIG. 2 the peeling is being accomplished by means of a pair of tweezers 6 which obtain purchase on portion 4 and pull it away from substrate 2.

Any useful practical means may be employed to start the peeling of portion 4 from substrate 2. One suitable means is by the use of a knife blade, such as the blade of knife 7.

In a preferred embodiment of the method of the present invention, the printed circuit is narrowed or "necked down" at the location where is is desired for the printed circuit to separate from the commoning portion. The narrowing facilitates such separation. Suh narrowing of "necking down" is shown at location 12 in FIGS. 1 and 2. Good separation during peeling has been accomplished when a copper printed circuit having a thickness of about 0.0022 inch (0.056 mm) is "necked" down" to a width of about 0.006 inch (0.1524 mm).

In an alternative embodiment of the method of the present invention, the blade of knife 7 is used to score printed circuit 3 between commoning portion 4 and selected portion 5 at locations 8 prior to peeling.

Lands or pads 9 are electrically isolated from each other after portion 4 has been peeled away, although they remain electrically connected to other portions of the printed circuit board by means of, for example, printed circuit lines 10 and plated thru holes 11.

The present invention has been disclosed in the above teachings and in the accompanying drawings with sufficient clarity and conciseness to enable one skilled in the art to make and to use the invention, to know the best mode for carrying out the invention, and to distinguish it from other inventions and from what is old. Many variations and obvious adaptations of the invention will readily come to mind and these are intended to be contained within the scope of the invention as claimed below.

## Claims

1. A method of making a printed circuit board (1) having a printed circuit (3) on a dielectric substrate (2) and having selected portions (5) of the printed circuit (3) electroplated, the method comprising:

   (a) placing on a dielectric substrate (2) a printed circuit (3), which circuit includes a commoning portion electrically connecting the selected portions;

   (b) electroplating the selected portions (5) using the commoning portion (4) as a commoning electrode; and

   (c) removing the commoning portion (4) from the substrate (2) by peeling.

2. The method of Claim 1 wherein the selected portions (5) are connector tabs arranged near the edge of a printed circuit board (1).

3. The method of Claim 1 wherein the selected portions (5) are electroplated with a conductive metal.

4. The method of Claim 3 wherein the conductive metal is gold, palladium or alloys thereof.

5. The method of Claim 1 which comprises the additional step, prior to (c), of scoring the printed circuit (3) between the commoning portion (4) and the selected portion (5).

6. The method of Claim 1 wherein, in (a), the commoning portions (4) are connected to the selected portions (5) by connecting portions (12) which are sufficiently narrow to facilitate separation of the commoning portion (4) from the selected portion (5) in (c).

7. A printed circuit board (1) comprising a printed circuit (3) on a dielectric substrate (2) having selected portions of the printed circuit electroplated, wherein the printed circuit board is made by the process of Claim 1.

## Patentansprüche

1. Verfahren zur Herstellung einer Schaltkreisplatte (1), versehen mit einer gedruckten Schaltung (3) auf einem dielektrischen Substrat (2) und mit ausgewählten, galvansich behandelten Abschnitten (5) der gedruckten Schaltung (3), wobei das Verfahren enthält:

(a) Anbringung einer gedruckten Schaltung (3) auf einem dielektrischen Substrat (2), wobei diese Schaltung einen gemeinsamen Abschnitt beinhaltet, welcher die ausgewählten Abschnitte elektrisch verbindet;

(b) galvanische Behandlung der ausgewählten Abschnitte (5), wobei der gemeinsame Abschnitt (4) als eine gemeinsame Elektrode benutzt wird; und

(c) Entfernung des gemeinsamen Abschnitts (4) von dem Substrat (2) durch Abschälen.

2. Verfahren nach Anspruch 1, worin die ausgewählten Abschnitte (5) Verbindungslappen sind, welche in der Nähe des Randes einer Schaltkreisplatte (1) angeordnet sind.

3. Verfahren nach Anspruch 1, worin die ausgewählten Abschnitte (5) mit einem leitenden Metall galvanisch behandelt werden.

4. Verfahren nach Anspruch 3, worin das leitende Metall aus Gold, Palladium oder Legierungen davon besteht.

5. Verfahren nach Anspruch 1, welches den zusätzlichen Schritt, vor (c), der Kerbmarkierung der gedruckten Schaltung (3) zwischen dem gemeinsamen Abschnitt (4) und dem ausgewählten Abschnitt (5) enthält.

6. Verfahren nach Anspruch 1, worin in (a) die gemeinsamen Abschnitte (4) mit den ausgewählten Abschnitten (5) durch Verbindungsabschnitte (12) verbunden sind, welche schmal genug sind, um die Abtrennung des gemeinsamen Abschnitts (4) von dem ausgewählten Abschnitt (4) von dem ausgewählten Abschnitt (5) in (c) zu erleichtern.

7. Schaltkreisplatte (1), versehen mit einer gedruckten Schaltung (3) auf einem dielektrischen Substrat (2) und mit ausgewählten, galvanisch behandelten Abschnitten der gedruckten Schaltung, worin die Schaltkreisplatte durch das Verfahren nach Anspruch 1 hergestellt wird.

## Revendications

1. Procédé de fabrication d'un panneau (1) de circuit imprimé comportant un circuit imprimé (3) sur un substrat diélectrique (2) et des parties choisies (5) du circuit imprimé (3) soumises à une électrodéposition, ledit procédé consistant à:

(a) placer sur un substrat diélectrique (2) un circuit imprimé (3) comportant une partie de branchement commun connectant électriquement les parties choisies,

(b) soumettre les parties choisies (5) à une électrodéposition en utilisant la partie de branchement commun (4) comme électrode de branchement commun, et

(c) retirer la partie de branchement commun (4) du substrat (2) en la détachant de celui-ci.

2. Procédé selon la revendication 1 dans lequel les parties choisies (5) sont des pattes de connexion disposées à proximité du bord d'un panneau (1) de circuit imprimé.

3. Procédé selon la revendication 2 dans lequel les parties choisies (5) sont recouvertes par électrodéposition d'un métal conducteur.

4. Procédé selon la revendication 3 dans lequel le métal conducteur est de l'or, du palladium ou des alliages de ces métaux.

5. Procédé selon la revendication 1 comprenant une étape supplémentaire, avant l'étape (c), consistant à inciser le circuit imprimé (3) entre la partie de branchement commun (4) et la partie choisie (5).

6. Procédé selon la revendication 1 dans lequel, en (a), la partie de branchement commun (4) est connectée aux parties choisies (5) par une partie de connexion (12) qui est suffisamment étroite pour faciliter la séparation de la partie de branchement commun (4) de la partie choisie (5) en (c).

7. Panneau (1) de circuit imprimé comportant un circuit imprimé (3) sur un substrat diélectrique (2) et ayant des parties choisies du circuit imprimé soumises à une électrodéposition, dans lequel ledit panneau est réalisé au moyen du procédé de la revendication 1.

FIG. 1

FIG. 2